# EUROPEAN PATENT APPLICATION

(11) **EP 4 398 321 A1**
(43) Date of publication of application: **10.07.2024**
(21) Application number: 22864689.9
(22) Date of filing: 01.09.2022
(51) Int. Cl.: H01L 33/62, F21S 2/00, F21V 5/04, F21V 19/00, G02B 6/12, G02B 6/42, H01L 33/58, H01S 5/0225, F21Y 113/13, F21Y 115/10

(54) **OPTICAL WAVEGUIDE PACKAGE AND LIGHT-EMITTING DEVICE**

(30) Priority: 01.09.2021 JP 2021142758
(71) Applicant: Kyocera Corporation, Kyoto-shi Kyoto 612-8501 (JP)
(72) Inventor: MATSUNAGA, Shougo, Kyoto-shi, Kyoto 612-8501 (JP); ITAKURA, Yoshiaki, Kyoto-shi, Kyoto 612-8501 (JP); MATSUMOTO, Hiroshi, Kyoto-shi, Kyoto 612-8501 (JP)
(74) Representative: Viering, Jentschura & Partner mbB Patent- und Rechtsanwälte
(86) International application number: PCT/JP2022/032950
(87) International publication number: WO 2023/033107

(57) **Abstract**

An optical waveguide package includes a substrate including a first surface, a cladding on the first surface and including a second surface facing the first surface, a third surface opposite to the second surface, and an element mount with an opening in the third surface, a core in the cladding, a first electrode located in the element mount, and a second electrode connected to the first electrode and extending to outside the element mount. A light-emitting element is mountable on the first electrode. The first electrode has a lower thermal expansion coefficient than the second electrode.

## Description

### TECHNICAL FIELD

The present disclosure relates to an optical waveguide package and a light-emitting device.

### BACKGROUND OF INVENTION

A known optical waveguide package and a known light-emitting device are described in, for example, Patent Literature 1.

### CITATION LIST

### PATENT LITERATURE

Patent Literature 1: Japanese Unexamined Patent Application Publication No. 10-308555

### SUMMARY

In an aspect of the present disclosure, an optical waveguide package includes a substrate including a first surface, a cladding on the first surface and including a second surface facing the first surface, a third surface opposite to the second surface, and an element mount with an opening in the third surface, a core in the cladding, a first electrode located in the element mount, and a second electrode connected to the first electrode and extending to outside the element mount. A light-emitting element is mountable on the first electrode. The first electrode has a lower thermal expansion coefficient than the second electrode.

In another aspect of the present disclosure, a light-emitting device includes the optical waveguide package, a light-emitting element in the element mount, and a lens on an optical path of light to be emitted through the core.

### BRIEF DESCRIPTION OF THE DRAWINGS

The objects, features, and advantages of the present disclosure will become more apparent from the following detailed description and the drawings.
FIG. 1 is an exploded perspective view of a light-emitting device according to a first embodiment.
FIG. 2 is a perspective view of the light-emitting device without a lid.
FIG. 3 is a cross-sectional view of the light-emitting device taken along line III-III in FIG. 2.
FIG. 4 is an enlarged cross-sectional view of a light-emitting element and its adjacent area.
FIG. 5 is an enlarged cross-sectional view of a light-emitting element and its adjacent area in a light-emitting device according to a second embodiment.
FIG. 6 is an enlarged cross-sectional view of a light-emitting element and its adjacent area in a light-emitting device according to a third embodiment.
FIG. 7 is a plan view of a light-emitting device according to a fourth embodiment.

### DESCRIPTION OF EMBODIMENTS

An optical waveguide package and a light-emitting device with the structure that forms the basis of an optical waveguide package and a light-emitting device according to one or more embodiments of the present disclosure will be described first.

Patent Literature 1 describes a hybrid waveguide optical circuit having a recessed cutout in a cladding on a substrate to receive an optical element. The cutout is covered airtightly with a sealing lid. The optical element in the cutout is electrically connected to, with bonding wires, electrical wiring for external connection located on the cladding surface.

With such a connection using bonding wires as described in Patent Literature 1, the light-emitting element in the element mount is at least at a predetermined distance from the electrical wiring. Such an optical waveguide package thus cannot be smaller. The electrode connected to the light-emitting element in the element mount may be extended between the substrate and the cladding to outside the element mount. This eliminates the bonding wires and allows size reduction.

The light-emitting element generates heat, which transfers through the electrode. The electrode has a temperature difference between a portion near the light-emitting element and a portion outside the element mount, and thus have different thermal expansions, causing deformation of the substrate or the cladding. This deformation can cause misalignment of the optical axis of the light-emitting element or separation of the cladding from the substrate, possibly degrading the characteristics and the reliability.

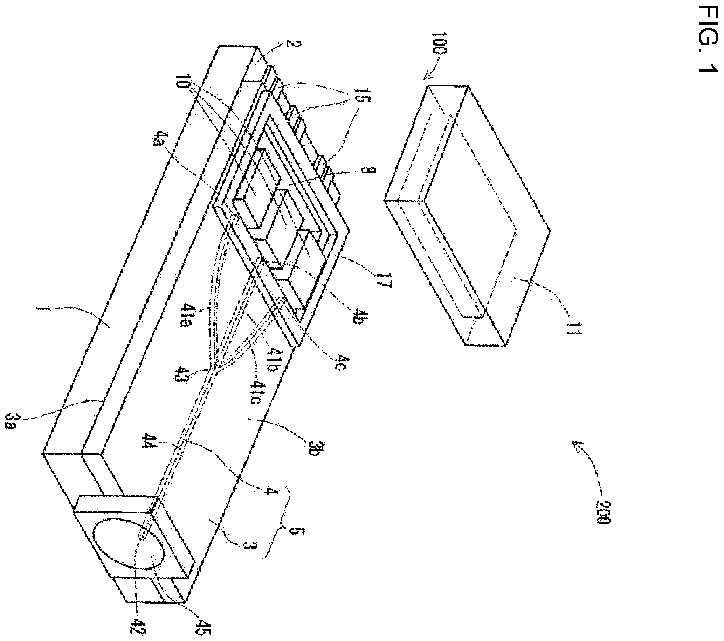

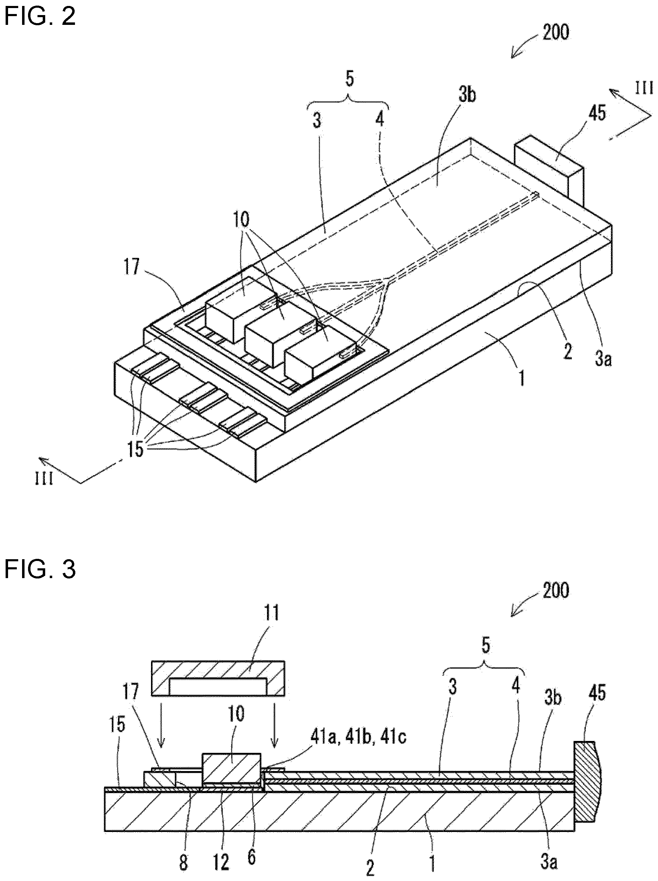

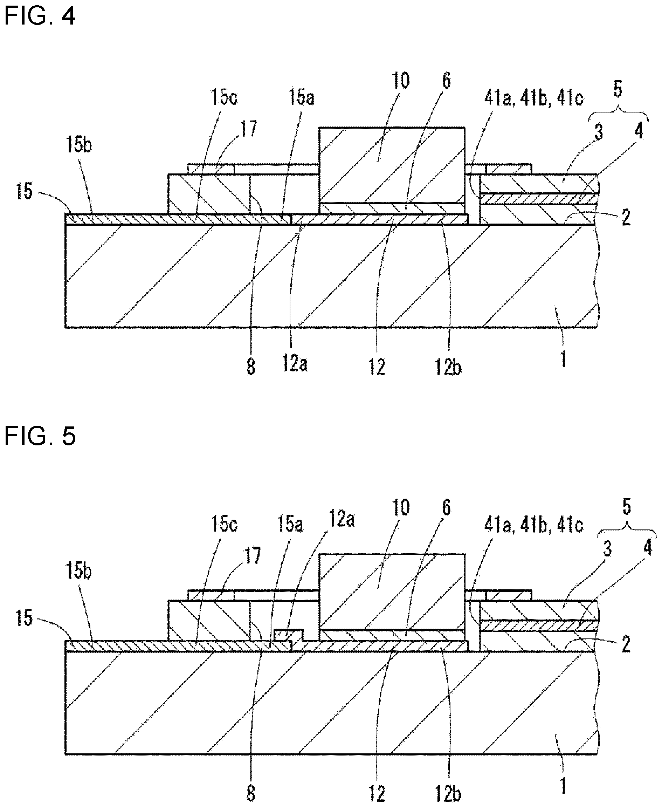

The optical waveguide package and the light-emitting device according to one or more embodiments of the present disclosure will now be described with reference to the accompanying drawings. FIG. 1 is an exploded perspective view of a light-emitting device according to a first embodiment. FIG. 2 is a perspective view of the light-emitting device without a lid. FIG. 3 is a cross-sectional view of the light-emitting device taken along line III-III in FIG. 2. FIG. 4 is an enlarged cross-sectional view of a light-emitting element and its adjacent area.

A light-emitting device 200 according to the first embodiment includes an optical waveguide package 100, light-emitting elements 10 in an element mount 8, and a lens 45 on the optical path of light emitted through a core 4. The optical waveguide package 100 includes a substrate 1 including a first surface 2, a cladding 3 located on the first surface 2 and including a second surface 3a facing the first surface 2, a third surface 3b opposite to the second surface 3a, and the element mount 8 with an opening in the third surface 3b, the core 4 located in the cladding 3, first electrodes 12 located in the element mount 8, and second electrodes 15 connected to the first electrodes 12 and extending to outside the element mount 8. The light-emitting elements 10 are mountable on the first electrodes 12. The light-emitting device 200 further includes a lid 11 covering the element mount 8.

In the present embodiment, the light-emitting device 200 includes three light-emitting elements 10 in the element mount 8 of the optical waveguide package 100. Each light-emitting element 10 is, for example, a light-emitting diode (LED) that emits red (R) light, green (G) light, or blue (B) light. The core 4 and the cladding 3 may be integral with each other to be an optical waveguide layer 5.

The substrate 1 may be a ceramic wiring board including dielectric layers made of a ceramic material. Examples of the ceramic material for the ceramic wiring board include sintered aluminum oxide, sintered mullite, sintered silicon carbide, sintered aluminum nitride, and sintered glass ceramic.

The substrate 1 may be an organic wiring board including dielectric layers made of, for example, an organic material. The organic wiring board may be, for example, a printed wiring board, a build-up wiring board, or a flexible wiring board. Examples of the organic material for the organic wiring board include an epoxy resin, a polyimide resin, a polyester resin, an acrylic resin, a phenolic resin, and a fluororesin.

The core 4 and the cladding 3 are included in the optical waveguide layer 5. The optical waveguide layer 5 may be made of, for example, glass such as quartz, or a resin. In the optical waveguide layer 5, both the core 4 and the cladding 3 may be made of glass or a resin. In some embodiments, one of the core 4 or the cladding 3 may be made of glass and the other may be made of a resin. The core 4 and the cladding 3 have different refractive indexes. The core 4 has a higher refractive index than the cladding 3. This difference in refractive index is used to fully reflect light at the interface between the core 4 and the cladding 3. More specifically, a material with a higher refractive index is used to form a path, which is then surrounded by a material with a lower refractive index. This structure confines light in the core 4 with the higher refractive index.

The core 4 includes multiple incident end faces 4a, 4b, and 4c and one emission end face 42. The core 4 includes multiple branching paths 41a, 41b, and 41c, a merging portion 43, and a joined path 44 between the incident end faces 4a, 4b, and 4c and the emission end face 42. The branching paths 41a, 41b, and 41c respectively include the incident end faces 4a, 4b, and 4c at one end. The branching paths 41a, 41b, and 41c merge together at the merging portion 43. The joined path 44 includes the emission end face 42 at one end.

Red (R) light, green (G) light, and blue (B) light emitted from the light-emitting elements 10 enter the respective branching paths 41a, 41b, and 41c through the respective incident end faces 4a, 4b, and 4c, pass through the merging portion 43 and the joined path 44, and are emitted through the emission end face 42. The light-emitting elements 10 are positioned in the element mount 8 with the center of each of the incident end faces 4a, 4b, and 4c of the branching paths 41a, 41b, and 41c aligned with the optical axis of the corresponding light-emitting element 10.

The element mount 8 may be a recess or a through-hole with an opening in the third surface 3b of the cladding 3. In the present embodiment, the element mount 8 is a through-hole extending from the third surface 3b to the second surface 3a of the cladding 3. In a plan view, a bond 17 surrounds the opening of the element mount 8 on the third surface 3b of the cladding 3. The bond 17 bonds the lid 11 to the third surface 3b of the cladding 3.

The lid 11 may be made of a glass material such as quartz, borosilicate, or sapphire. The bond 17 may be made of any material that can airtightly bond the lid 11 to the cladding 3, such as Au-Sn or Sn-Ag-Cu solder, an Ag or Cu metal nanoparticle paste, or a glass paste.

The lens 45 is located on the optical path of light emitted through the core 4. The lens 45 may collimate or condense the light emitted through the core 4. The lens 45 is, for example, a plano-convex lens with a flat incident surface and a convex emission surface.

The first electrodes 12 and the second electrodes 15 will be described. The first electrodes 12 are located in an exposed portion of the first surface 2 of the substrate 1 facing the element mount 8. The first electrodes 12 are fully located in the element mount 8. The second electrodes 15 extend from inside to outside the element mount 8. The first electrodes 12 have a lower thermal expansion coefficient than the second electrodes 15. The light-emitting elements 10 are mounted on the first electrodes 12. During operation, the first electrodes 12 have higher temperatures than the second electrodes 15 with heat generated by the light-emitting elements 10. The second electrodes 15 are continuous with the first electrodes 12 and receive heat generated by the light-emitting elements 10 through the first electrodes 12. The second electrodes 15 are farther from the light-emitting elements 10 than the first electrodes 12 and dissipate heat in portions outside the element mount 8. The second electrodes 15 thus have lower temperatures than the first electrodes 12.

When the first electrodes 12 and the second electrodes 15 are not separate components and are integral as one electrode extending from the portion in which the light-emitting elements 10 are mounted to outside the element mount 8, such an electrode has the same thermal expansion coefficient throughout. The portion of the electrode in which the light-emitting elements 10 are mounted thus has a higher temperature with a greater thermal expansion whereas the portion outside the element mount 8 has a lower temperature with a less thermal expansion. The difference in thermal expansion deforms the substrate 1 or the cladding 3. In the present embodiment, as described above, the first electrodes 12 that can have higher temperatures have a lower thermal expansion coefficient, and the second electrodes 15 that can have lower temperatures have a higher thermal expansion coefficient. This reduces the difference in thermal expansion between the first electrodes 12 and the second electrodes 15, thus reducing deformation of the substrate 1 and the cladding 3. This reduced deformation reduces degradation in the characteristics and the reliability of the light-emitting device 200. The first electrodes 12 and the second electrodes 15 allow external connection without bonding wires, thus reducing the size of the optical waveguide package 100 and the light-emitting device 200.

The structure in which the first electrodes 12 have a lower thermal expansion coefficient than the second electrodes 15 can reduce deformation of the substrate 1 and the cladding 3 more than the structure in which the first electrodes 12 have the same thermal expansion coefficient as the second electrodes 15. The degree of the difference in thermal expansion coefficient may be determined as appropriate for, for example, heat generated by the light-emitting elements 10 mounted or for the materials of the substrate 1 and the cladding 3. The first electrodes 12 and the second electrodes 15 may be, for example, made of different materials to have different thermal expansion coefficients. In one example, the first electrodes 12 may be made of three layers, or more specifically, layers of titanium (Ti), platinum (Pt), and gold (Au), and the second electrodes 15 may be made of one layer, or more specifically, a layer of aluminum (Al).

Each first electrode 12 includes a first end 12a connected to a second electrode 15. Each second electrode 15 includes a second end 15a connected to a first electrode 12. Each first electrode 12 includes a third end 12b opposite to the first end 12a. A light-emitting element 10 is mounted on the third end 12b. Each second electrode 15 includes a fourth end 15b opposite to the second end 15a, and a middle portion 15c continuous with the second end 15a and the fourth end 15b. The middle portion 15c of each second electrode 15 extends between the cladding 3 and the first surface 2 of the substrate 1.

In the present embodiment, as illustrated in FIG. 4, the first end 12a of each first electrode 12 and the second end 15a of the corresponding second electrode 15 are connected with the first end 12a and the second end 15a abutting against each other. An element bond 6 is located between the third end 12b of each first electrode 12 and the corresponding light-emitting element 10. Although the light-emitting elements 10 may be bonded directly to the first electrodes 12, the bonding strength is increased when the device bond 6 is used. The element bond 6 may be, for example, an Au-Sn (gold-tin) alloy.

FIG. 5 is an enlarged cross-sectional view of a light-emitting element and its adjacent area in a light-emitting device according to a second embodiment. The second embodiment is the same as the first embodiment except the connection between the first electrodes 12 and the second electrodes 15. The other components will not be described in detail. In the present embodiment, the first end 12a of each first electrode 12 covers the second end 15a of the corresponding second electrode 15. In the first embodiment, the first electrodes 12 and the second electrodes 15 are connected with their end faces in contact with each other. The contact area is thus the area of the end face. In the second embodiment, the contact area includes a portion of the second end 15a covered with the first end 12a. The contact area is thus larger with less contact resistance. This improves the connection reliability between the first electrodes 12 and the second electrodes 15.

An example method for forming the element mount 8 will now be described. The method includes forming the second electrodes 15 on the first surface 2 of the substrate 1 and placing the optical waveguide layer 5 including the cladding 3 and the core 4 on the first surface 2 including the second electrodes 15. The portion of the cladding 3 to be the element mount 8 is removed by etching to expose the second electrodes 15 and expose the portions of the first surface 2 in which the first electrodes 12 are to be formed. The first electrodes 12 are formed and connected to the second electrodes 15. The first ends 12a of the first electrodes 12 may be formed to cover the second ends 15a of the second electrodes 15. The portion of the surface of each second electrode 15 exposed by etching the element mount 8 is etched and roughened. The surface of the second end 15a of each second electrode 15 is also roughened, with improved adhesion with the first end 12a covering the second end 15a. The element mount 8 may be formed with any method other than the above method. For example, the substrate 1 on which the second electrodes 15 are formed and the optical waveguide layer 5 with the element mount 8 may be prepared separately and bonded to each other.

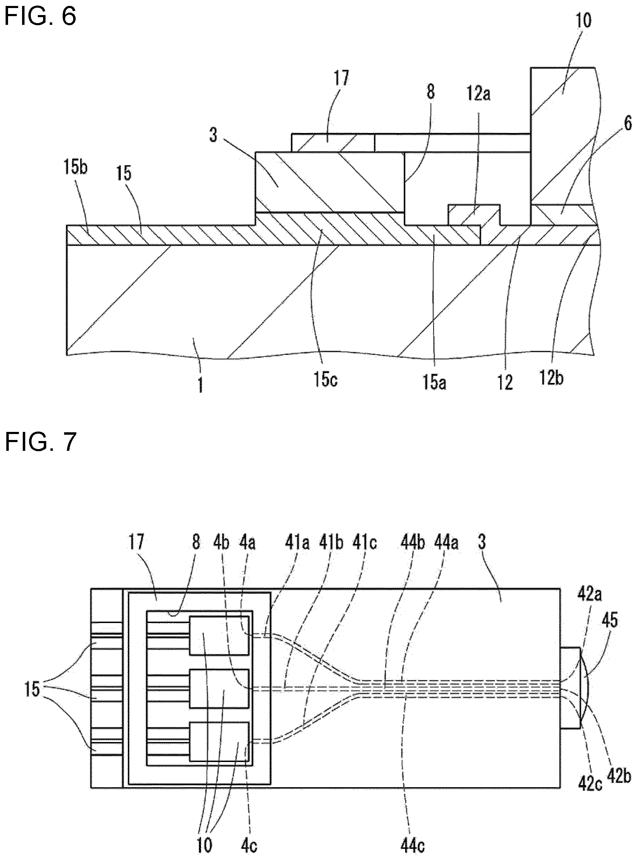

FIG. 6 is an enlarged cross-sectional view of a light-emitting element and its adjacent area in a light-emitting device according to a third embodiment. The third embodiment is the same as the second embodiment except the structure of the second electrodes 15. The other components will not be described in detail. Each second electrode 15 in the present embodiment includes a step between the middle portion 15c and the second end 15a. In other words, the second end 15a is thinner than the middle portion 15c. The second electrode 15 including the step has a larger surface area than a second electrode 15 including no step, thus increasing heat dissipation from the surface of the second electrode 15. This improves the efficiency of cooling the light-emitting elements 10 and extends the service lives of the light-emitting elements 10. Each second electrode 15 may further include a step between the middle portion 15c and the fourth end 15b. The second electrode 15 in this structure has a larger surface area than a second electrode 15 including no step, thus increasing heat dissipation from the surface of the second electrode 15. The increased heat dissipation from the surface of each second electrode 15 lowers the temperature of the second electrode 15 and also the temperature of the corresponding first electrode 12. This also reduces deformation resulting from thermal expansion, thus extending the service life.

As described above, the element mount 8 may be formed by etching. An excess amount of etching causes the second ends 15a of the second electrodes 15 to be over-etched and thinner. The fourth end 15b may be etched in the same or similar manner to form the step nearer the fourth end 15b.

FIG. 7 is a plan view of a light-emitting device according to a fourth embodiment. In the first to third embodiments, the core 4 includes three branching paths 41a, 41b, and 41c merged at the merging portion 43 to be the single joined path 44 including the single emission end face 42. The light-emitting device including an optical waveguide package according to the fourth embodiment may include three independent cores 44a, 44b, and 44c as in the plan view in FIG. 7. As in the above embodiments, the incident end faces 4a, 4b, and 4c of the three cores 44a, 44b, and 44c each have the center aligned with the optical axis of the corresponding light-emitting element 10. The three incident end faces 4a, 4b, and 4c are thus located apart from one another to align with the respective light-emitting elements 10. The three cores 44a, 44b, and 44c in the present embodiment include emission end faces 42a, 42b, and 42c located adjacent to one another. The three cores 44a, 44b, and 44c may be gathered adjacent to one another between the incident end faces 4a, 4b, and 4c and the emission end faces 42a, 42b, and 42c, and extend parallel to one another to the emission end faces 42a, 42b, and 42c. Light beams emitted through the cores 44a, 44b, and 44c may be emitted parallel to one another through, for example, the single lens 45. In this case, for example, the images resulting from the light beams emitted from the three emission end faces 42a, 42b, and 42c may be combined using, for example, an external device.

The optical waveguide package according to one or more embodiments of the present disclosure may be implemented in forms (1) to (4) below.
(1) An optical waveguide package, comprising:
   a substrate including a first surface;
   a cladding on the first surface, the cladding including a second surface facing the first surface, a third surface opposite to the second surface, and an element mount with an opening in the third surface;
   a core in the cladding;
   a first electrode on which a light-emitting element is mountable, the first electrode being located in the element mount; and
   a second electrode connected to the first electrode and extending to outside the element mount,
   wherein the first electrode has a lower thermal expansion coefficient than the second electrode.
(2) The optical waveguide package according to (1), wherein
   the first electrode includes a first end connected to the second electrode,
   the second electrode includes a second end connected to the first electrode, and
   the first end covers the second end.
(3) The optical semiconductor package according to (1) or (2), wherein
   the second end includes an etched surface.
(4) The optical waveguide package according to any one of (1) to (3), wherein
   the second electrode includes a step between a middle portion and the second end, and the middle portion is continuous with the second end and located between the cladding and the first surface.
   The light-emitting device according to one or more embodiments of the present disclosure may be implemented in form (5) below.
(5) A light-emitting device, comprising:
   the optical waveguide package according to any one of (1) to (4);
   a light-emitting element in the element mount; and
   a lens on an optical path of light to be emitted through the core.

The optical waveguide package and the light-emitting device according to one or more embodiments of the present disclosure can be smaller and have reduced degradation in the characteristics and the reliability.

The light-emitting elements 10 are not limited to light-emitting diodes (LEDs), and may be, for example, laser diodes (LDs) or vertical-cavity surface-emitting lasers (VCSELs).

Although the embodiments of the present disclosure have been described in detail, the present disclosure is not limited to the embodiments described above, and may be changed or varied in various manners without departing from the spirit and scope of the present disclosure. The components described in the above embodiments may be entirely or partially combined as appropriate unless any contradiction arises.

### REFERENCE SIGNS

- 1: substrate
- 2: first surface
- 3: cladding
- 3a: second surface
- 3b: third surface
- 4; 44a, 44b, 44c: core
- 4a, 4b, 4c: incident end face
- 5: optical waveguide layer
- 6: element bond
- 8: element mount
- 10: light-emitting element
- 11: lid
- 12: first electrode
- 12a: first end
- 12b: third end
- 15: second electrode
- 15a: second end
- 15b: fourth end
- 15c: middle portion
- 17: bond
- 41a, 41b, 41c: branching path
- 42; 42a, 42b, 42: cemission end face
- 43: merging portion
- 44: joined path
- 45: lens
- 100: optical waveguide package
- 200: light-emitting device

## Claims

1. An optical waveguide package, comprising:
a substrate including a first surface;
a cladding on the first surface, the cladding including a second surface facing the first surface, a third surface opposite to the second surface, and an element mount with an opening in the third surface;
a core in the cladding;
a first electrode on which a light-emitting element is mountable, the first electrode being located in the element mount; and
a second electrode connected to the first electrode and extending to outside the element mount,
wherein the first electrode has a lower thermal expansion coefficient than the second electrode.

2. The optical waveguide package according to claim 1, wherein
the first electrode includes a first end connected to the second electrode,
the second electrode includes a second end connected to the first electrode, and
the first end covers the second end.

3. The optical semiconductor package according to claim 2, wherein
the second end includes an etched surface.

4. The optical waveguide package according to claim 2 or claim 3, wherein
the second electrode includes a step between a middle portion and the second end, and the middle portion is continuous with the second end and located between the cladding and the first surface.

5. A light-emitting device, comprising:
the optical waveguide package according to any one of claims 1 to 4;
a light-emitting element in the element mount; and
a lens on an optical path of light to be emitted through the core.
